# EUROPEAN PATENT APPLICATION

(11) **EP 2 676 923 A1**
(43) Date of publication of application: **25.12.2013**
(21) Application number: 12172788.7
(22) Date of filing: 20.06.2012
(51) Int. Cl.: B81C 1/00

(54) **Method for producing conductive lines in close proximity in the fabrication of micro-electromechanical systems**

(71) Applicant: IMEC, 3001 Leuven (BE)
(72) Inventor: Severi, Simone, 3001 Leuven (BE); Verbist, Agnes, 3001 Leuven (BE)
(74) Representative: Clerix, André

(57) **Abstract**

The invention is related to a method for producing parallel conductive lines on the surface of a MEMS device. In the method of the invention, a first conductive line is produced, followed by the deposition and planarization of a dielectric layer (such as an oxide layer), the formation of a trench in said dielectric layer, the filling of said trench with a conductive material and the planarization of said material, to obtain a second conductive line formed by the filled trench. The production technique allows to produce lines at a mutual distance of less than 500nm and having a width of less than 500nm, without losing the control over the width definition of the lines.

## Description

### Field of the Invention

The present invention is related to micro-electromechanical systems (MEMS), in particular to the patterning of metal or semiconductor lines in a MEMS device.

### State of the art.

In MEMS processing, specific applications require the patterning of one metal and one semiconductor electrical line in close proximity to each other. The impact of these lines on the mechanical properties of the MEMS device is minimized by limiting their dimensions and area. The use of two different materials with different material properties such as resistivity or thermal conductivity allows the design of advanced sensing systems capable of reaching high resolutions. The required spacing between the two lines as well as the width of the lines is often lower than 500nm. An example of such a system is described in W02011/064405. In this document a MEMS resonator is described with two resistor lines in close thermal contact with the resonator bar. The two lines have different thermal coefficients of resistance, so that the voltage/temperature curves for the two lines intersect at a predefined temperature. The continuous measurement of the two resistance values allows to produce a control signal suitable for maintaining the resonator at said predefined temperature in order to ensure stable operation of the device.

The classic way of producing electrically conductive lines of different materials on a MEMS device is by a sequence of lithography and etch steps. This sequence starts with the deposition and patterning of a first conductive layer formed of the first material, resulting in a first conductive line of a given width and height. Then a layer of a second conductive material is deposited and patterned to form the second conductive line. However, when the lines are very close together, the topography created by the first line will cause an error in the resist definition during the second litho step. For this reason, the dimensions of the second line cannot be accurately reproduced in the production process.

### Summary of the invention

The problems described above in relation to the prior art are solved by the method as disclosed in the appended claims. The invention is related to a method for producing closely spaced conductive lines on the surface of a MEMS device. In the method of the invention, a first conductive line is produced, followed by the deposition and planarization of a dielectric layer (such as an oxide layer), the formation of a trench in said dielectric layer, the filling of said trench with a conductive material and the planarization of said material, to obtain a second conductive line formed by the filled trench. The production technique allows to produce lines at a mutual distance of less than 500nm and having a width of less than 500nm, without losing the control over the width definition of the lines.

The invention is in particular related to a method for producing at least partially parallel conductive lines on top of a Micro-Electromechanical system (MEMS) device, said method comprising the steps of :
- Providing a MEMS device, said device comprising a component with a flat upper surface,
- Producing a first conductive line on said upper surface,
- depositing a dielectric layer onto said upper surface, said dielectric layer covering said first conductive line,
- planarizing said dielectric layer, to thereby produce a planarized dielectric layer having a thickness that is greater than the height of the first conductive line,
- patterning said planarized dielectric layer, to thereby create a trench which is at least partially parallel to the first conductive line, at least one parallel portion of said trench being at a distance lower than 500nm from said first line,
- filling said trench with a conductive material, and planarizing said conductive material, thereby obtaining a second conductive line, the first and second lines being embedded in said dielectric layer, the height of the second line being higher than the height of the first line.

The method may further comprise the step of removing said dielectric layer, performed after the step of filling said trench and planarizing said conductive material.

According to an embodiment, said first and second conductive lines are made of different conductive materials. According to a particular embodiment, one of said lines is a metal line and the other is a semiconductor line.

According to further embodiments, the maximum or average distance between said conductive lines is less than 400nm, or less than 300nm.

According to an embodiment, the width of said conductive lines is less than 500nm.

According to an embodiment, an additional substrate portion is provided adjacent to said component, said additional portion having equally a flat upper surface and having the same height as said component, and wherein said conductive lines are produced on top of the joint upper surface of said component and said adjacent portion.

At least a part of said additional portion may be removed after the step of planarizing said conductive material, thereby obtaining said conductive lines extending outward laterally from said component.

According to an embodiment, said MEMS device is a resonator, said component being a resonator bar provided with an insulating layer on its upper surface, wherein said conductive lines are sensor lines having different temperature-dependent characteristics and being configured to measure the temperature of the resonator bar in order to produce a control signal for maintaining said temperature at a predefined value.

### Brief description of the figures

Figures 1a to 1f are a schematic representation of the steps in the method according to the invention.

Figure 2 illustrates a specific embodiment of the method according to the invention.

Figure 3 illustrates two possible shapes of a conductive lines produced according to the method of the invention.

### Detailed description of the invention

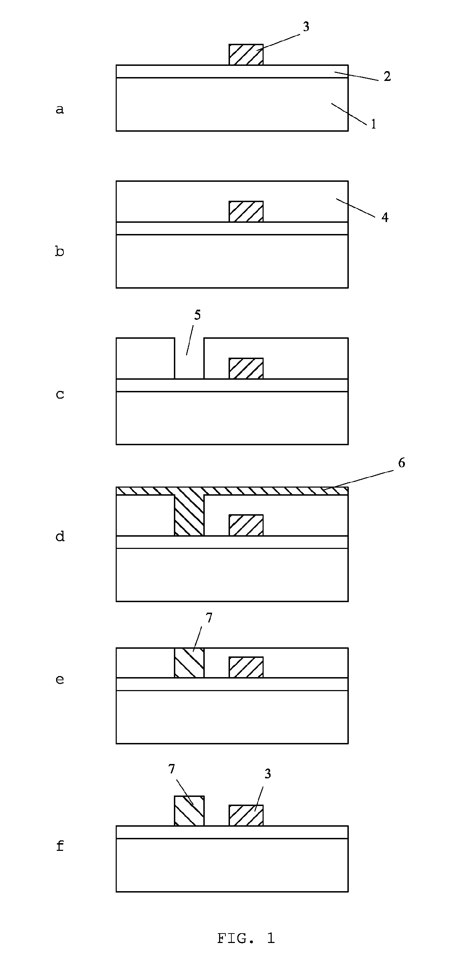

The method steps of the invention are explained with reference to figures 1a to 1f. The conductive substrate 1 provided with the insulating layer 2 represents the top of a MEMS device component (Fig. 1a). In the case of a resonator as described in WO2011/064405, the component in question may be the resonator bar onto which two conductive lines are to be produced. The resonator bar is provided with an insulating layer 2, which electrically isolates the conductive lines from the resonator bar, whilst still ensuring a close thermal contact between said lines and the resonator bar.

The following steps are then performed:
- Producing a first conductive line 3 on the insulating layer (Fig. 1a). This is preferably done by a standard litho/etch step. The first conductive line may be a metal or a semiconductor line. The width of the line is preferably less than 500nm, more preferably less than 400nm or less than 300nm,
- depositing a dielectric layer 4 onto said insulating layer 2, said dielectric layer covering said first conductive line 3. The dielectric is preferably an oxide, for example silicon oxide, deposited by a suitable deposition technique,
- planarizing said dielectric layer, to thereby produce a planarized dielectric layer 4 having a thickness that is greater than the height of the first conductive line 3 (Fig. 1b). The planarization can take place by known CMP techniques (Chemical Mechanical Polishing),
- patterning said planarized dielectric layer, to thereby create a trench 5 (Fig. 1c). The trench is substantially parallel to the first conductive line over at least a part of its length. In at least one portion of the trench where the trench is parallel to the first line, the distance between the trench and the first line is preferably lower than 500nm. According to a further embodiment, said distance is lower than 400nm. The width of the trench is preferably less than 500nm, more preferably less than 400nm or less than 300nm. The patterning step may take place by standard litho/etch techniques,
- filling said trench with a conductive material 6 (Fig. 1d). In order to fill the trench completely and form a layer 6' of substantially constant thickness on top of the dielectric layer 4, the filling step must take place by a conformal deposition technique such as Chemical Vapour Deposition (CVD), e.g. CVD deposition of a Silicon Germanium compound (SiGe).
- Planarizing the conductive material (Fig. 1e), thereby obtaining a second conductive line 7, the first and second lines being embedded in said dielectric layer. Planarization may take place by standard CMP. The planarization is stopped when a desired height of the second line is reached.
- According to an embodiment, the preceding steps are followed by removing said dielectric layer (Fig. 1f), e.g. by a dry etch (preferably vapour HF).

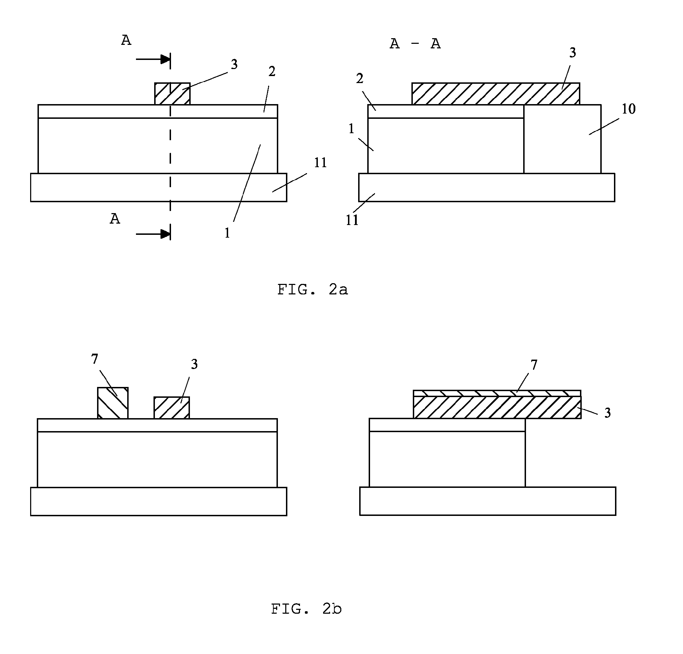

According to a specific embodiment, the conductive lines extend outwards laterally from the MEMS components onto which they are produced. This is the case for the resonator device described above: the lines must extend outward from the resonator bar in order to be connected electrically to other components of the MEMS device. In order to produce such a device, the substrate to which the method of the invention is applied must look like the substrate shown in figure 2a. Adjacent to the substrate 1 and the insulating layer 2, an additional substrate portion 10 is present. For example, the substrate 1 and additional portion 10 may be produced on a base substrate 11. The additional portion 10 has the same height as the substrate/insulating layer (1,2) combined. The material of the additional portion 10 may be the same as the material of the dielectric layer 4 deposited on top of the first line (figure 1b). In the latter case, the additional portion 10 may be removed at the end of the method, to release the conductive lines 3/7, leaving a portion of said lines extended outwards from the substrate 1, as illustrated in figure 2b. The material of the additional portion 10 may be a different material than the dielectric layer 4. Preferably said additional portion is of a material that is removable together with the dielectric layer 4 in the same removal step.

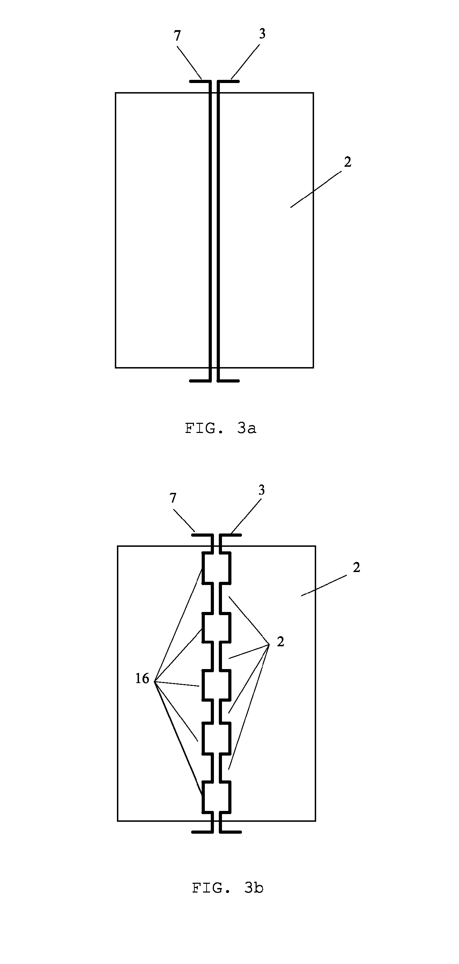

As stated, the conductive lines 7 and 3 are substantially parallel over at least a portion of their distance. According to an embodiment, they may be parallel along the entire length of the portion of said lines that is in contact with the MEMS component onto which they are produced, as illustrate in figure 3a. Figure 3b shows another embodiment, wherein the lines are parallel in first and second portions 15/16 of the MEMS component, the distance between the lines being smaller in the first portions 15 than the distance in the second portions 16. According to the preferred embodiment, the distance between the lines 7/3 is less than 500nm in the portions 15 where said distance is smaller.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A method for producing at least partially parallel conductive lines on top of a Micro-Electromechanical system (MEMS) device, said method comprising the steps of :
- Providing a MEMS device, said device comprising a component (1,2) with a flat upper surface,
- Producing a first conductive line (3) on said upper surface,
- depositing a dielectric layer (4) onto said upper surface, said dielectric layer covering said first conductive line (3),
- planarizing said dielectric layer (4), to thereby produce a planarized dielectric layer having a thickness that is greater than the height of the first conductive line,
- patterning said planarized dielectric layer, to thereby create a trench (5) which is at least partially parallel to the first conductive line, at least one parallel portion of said trench being at a distance lower than 500nm from said first line,
- filling said trench (5) with a conductive material (6), and planarizing said conductive material, thereby obtaining a second conductive line (7), the first and second lines being embedded in said dielectric layer, the height of the second line being higher than the height of the first line.

2. Method according to claim 1, further comprising the step of removing said dielectric layer (4), performed after the step of filling said trench (5) and planarizing said conductive material (6).

3. Method according to claim 1, wherein said first and second conductive lines are made of different conductive materials.

4. Method according to claim 1 or 2, wherein one of said lines is a metal line and the other is a semiconductor line.

5. Method according to any one of the preceding claims, wherein the maximum or average distance between said conductive lines is less than 400nm, or less than 300nm.

6. Method according to any one of the preceding claims, wherein the width of said conductive lines is less than 500nm.

7. Method according to any one of the preceding claims, wherein an additional substrate portion (10) is provided adjacent to said component, said additional portion having equally a flat upper surface and having the same height as said component, and wherein said conductive lines (3,7) are produced on top of the joint upper surface of said component and said adjacent portion.

8. Method according to claim 7, wherein at least a part of said additional portion (10) is removed after the step of planarizing said conductive material (6), thereby obtaining said conductive lines (3,7) extending outward laterally from said component.

9. Method according to any one of the preceding claims, wherein said MEMS device is a resonator, said component being a resonator bar (1) provided with an insulating layer (2) on its upper surface and wherein said conductive lines (3,7) are sensor lines having different temperature-dependent characteristics and being configured to measure the temperature of the resonator bar in order to produce a control signal for maintaining said temperature at a predefined value.
